(19) Europäisches Patentamt European Patent Office Office européen des brevets

(11) **EP 2 133 705 A1**

(12) **EUROPEAN PATENT APPLICATION**
published in accordance with Art. 153(4) EPC

(43) Date of publication:
**16.12.2009 Bulletin 2009/51**

(51) Int Cl.:
***G01R 31/28*** *(2006.01)*

(21) Application number: **07740341.8**

(22) Date of filing: **29.03.2007**

(86) International application number:
**PCT/JP2007/056903**

(87) International publication number:
**WO 2008/120362 (09.10.2008 Gazette 2008/41)**

(84) Designated Contracting States:
**AT BE BG CH CY CZ DE DK EE ES FI FR GB GR HU IE IS IT LI LT LU LV MC MT NL PL PT RO SE SI SK TR**

(71) Applicant: **Fujitsu Limited**
**Kawasaki-shi, Kanagawa 211-8588 (JP)**

(72) Inventor: **OTAKE, Takashi**
**Kawasaki-shi**
**Kanagawa 211-8588 (JP)**

(74) Representative: **Fenlon, Christine Lesley**
**Haseltine Lake LLP**
**Lincoln House, 5th Floor**
**300 High Holborn**
**London WC1V 7JH (GB)**

(54) **FAULT LOCATING DEVICE, FAULT LOCATING METHOD, AND INTEGRATED CIRCUIT**

(57) A faulty site identification apparatus (20) for identifying a faulty site in an integrated circuit, the apparatus includes a scan chain (12) that is constituted by coupling a plurality of sequential circuits (13), the scan chain outputs an output data array by shifting out setting data that is set to each of the plurality of sequential circuits (13); a setting section (22) that sets a predefined value to at least one sequential circuit (18) of the plurality of sequential circuits (13) as the setting data; and an identification section (24) that identifies a faulty site in the scan chain (12) on the basis of the output data array from the scan chain (12) and a location of the at least one sequential circuit (18) in the scan chain (12) . Thereby, any faulty site in the scan chain can be easily and quickly identified in the scan test.

FIG. 1

**Description**

TECHNICAL FIELD

The embodiment discussed herein relates to a technique to identify a faulty site in an integrated circuit including a scan chain constituted by coupling multiple sequential circuits.

BACKGROUND ART

For integrated circuits, such as LSIs (large-scale integrated circuits), for example, the design for testability technique, generally called as "scan designs" has been adopted. In an integrated circuit for which such a scan design is adopted, a scan chain is constituted using sequential circuits internal to the integrated circuit, and a scan test is executed to identify faults (failures), such as fixed faults, in the sequential circuits constituting this scan chain (see Patent References 1 and 2 listed below, for example).

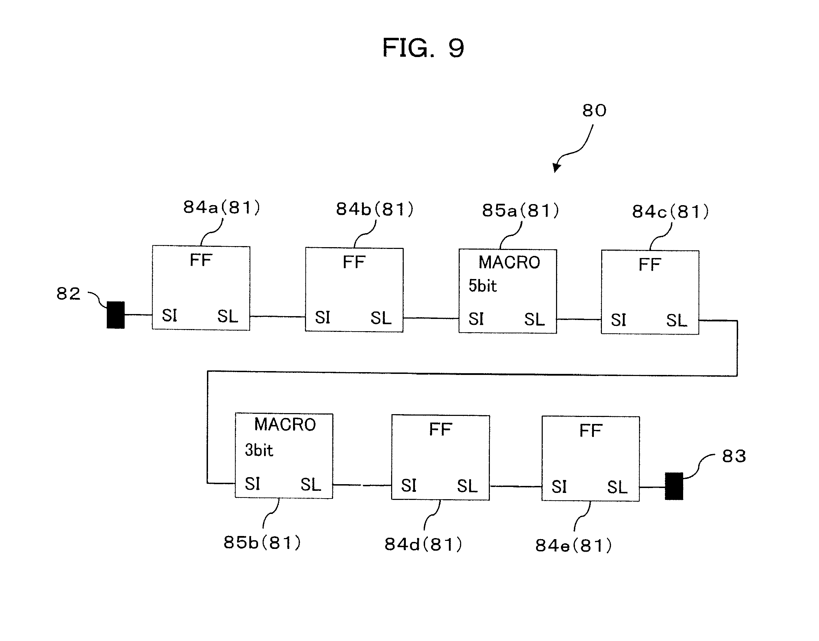

FIG. 9 is a diagram schematically illustrating an example of the configuration of a conventional scan chain.
As depicted in FIG. 9, for example, a scan chain 80 is constituted by multiple sequential circuits 81 that are coupled in series, and is configured as a circuit different from circuits (not depicted) that function during the normal operation (system operation) of the integrated circuit.
In addition, an SI (Scan-In) pin 82 and an SO (Scan-Out) pin 83 are provided at the two ends of the scan chain 80. The SI pin 82 is an entry of shift data that is entered to the scan chain 80, and the SO pin 83 is an exit of the shift data.

As used herein, "shift data" refers to data that is used to assess whether or not a circuit included in the integrated circuit conforms to the required criteria, and sometimes referred to as test vectors.
The sequential circuits 81 are set with data from a logic circuit included in the integrated circuit as setting data, and are embodied by flip-flops (labeled as "FF" in the drawings) 84a-84e and macros (specific macros) 85a and 85b, as depicted in FIG. 9, for example.

In the example depicted in FIG. 9, the scan chain 80 is constituted by coupling the sequential circuits 81 in series; more specifically, a first flip-flop 84a, a second flip-flop 84b, a first macro 85a, a third flip-flop 84c, a second macro 85b, a fourth flip-flop 84d, and a fifth flip-flop 84e, in this sequence from the SI pin 82 to the SO pin 83.

Note that the reference symbols 84a-84e are used when a reference to a specific one of the flip-flops is required to be made while reference symbol 84 is used when reference is made to any one of the flip-flops. Note that the reference symbols 85a, 85b are used when a reference to a specific one of the macros is required to be made while reference symbol 85 is used when reference is made to any of the macros.

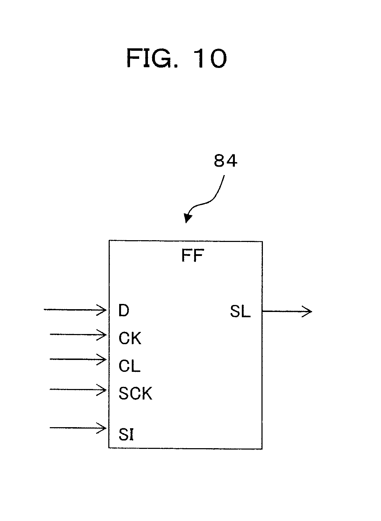

FIG. 10 is a diagram schematically illustrating an example of the configuration of a flip-flop constituting the conventional scan chain.
A flip-flop 84 is set with 1-bit data as setting data, and is configured to include a data input terminal D, a clock signal input terminal CK (Clock), a shift data input terminal SI, a scan clock signal input terminal SCK (Scan-Clock), a data output terminal SL (Slave-out), and a reset signal input terminal CL (Clear), as depicted in FIG. 10.

The data input terminal D (Data) receives data to be set from a logic circuit that functions during the normal operation (system operation) of the integrated circuit as setting data, and a clock signal that is used for setting (capturing) the setting data is entered (applied) to the clock signal input terminal CK.
Into the flip-flop 84, 1-bit data from the logic circuit that functions during the normal operation (system operation) of the integrated circuit is set as setting data via the data input terminal D every time a clock signal is entered to the clock signal input terminal CK.

The shift data input terminal SI of the flip-flop 84 receives data from the previous-stage sequential circuit 81 in the scan chain 80, and a scan clock signal for executing a shift operation in the scan chain 80 during a scan test is entered (applied) to the scan clock signal input terminal SCK.
As used herein, the "shift operation" refers to an operation in the scan chain 80 wherein shift data is sequentially entered (shifted in) from the SI pin 82 on a bit-by-bit basis and the setting data that has been set to each of the multiple sequential circuits 81 is sequentially output (shifted out) from the SO pin 83 on a bit-by-bit basis.

The data output terminal SL outputs the setting data that has been set to the logic circuit that functions during the normal operation (system operation) of the integrated circuit, and the next-stage sequential circuit 81 in the scan chain 80.
The flip-flop 84 captures 1-bit data from the shift data input terminal SI as well as executing a shift operation by outputting 1-bit setting data that has been internally set from the data output terminal SL to the next-stage sequential circuit 81 every time a scan clock signal is entered to the scan clock signal input terminal SCK.

A reset signal for resetting the internal information is entered (applied) to the reset signal input terminal CL.
Thus, in the flip-flop 84, 1-bit data from the logic circuit that functions during the normal operation (system operation) of the integrated circuit is set as setting data in response to an input of a clock signal, a 1-bit shift operation is executed in the scan chain 80 in response to an input of a scan clock signal, and the information set internal to the flip-flop 84 is reset in response to an input of a reset signal.

Into a macro 85, multiple-bit data is set as setting data, and includes multiple flip-flops, for example, and is configured to be scannable.

In the example depicted in FIG. 9, into the first macro 85a, 5-bit data is set as setting data, and into the second macro 85b, 3-bit data is set as setting data.

In addition, a macro 85 is configured to include a shift data input terminal SI and a data output terminal SL, as depicted in FIG. 9.

Data from the previous-stage sequential circuit 81 in the scan chain 80 is entered to the shift data input terminal SI of the macro 85 on a bit-by-bit basis.

The data output terminal SL in the macro 85 outputs the setting data that has been set to the logic circuit that functions during the normal operation (system operation) of the integrated circuit, and the next-stage sequential circuit 81 in the scan chain 80 on a bit-by-bit basis.

Note that although the macro 85 is configured to include a data input terminal D, a clock signal input terminal CK, a scan clock signal input terminal SCK, a reset signal input terminal CL, and the like, in addition to the shift data input terminal SI and the data output terminal SL described above, an illustration of these as well as a description thereof are omitted for the brevity of the description.

Thus, in the macro 85, multiple-bit data (5 bits for the macro 85a, for example) from the logic circuit that functions during the normal operation (system operation) of the integrated circuit is set as setting data in response to an input of a clock signal, a 1-bit shift operation is executed in the scan chain 80 in response to an input of a scan clock signal, and the information set internal to the macro 85 is reset in response to an input of a reset signal.

The scan chain 80 receives (is shifted in) shift data from the SI pin 82, carries out shift operations, thereby outputting an output data array from the SO pin 83.

FIGS. 11-13 are diagrams illustrating an example of a scan test technique using a conventional scan chain. FIG. 11 is a diagram schematically illustrating a situation after each of the multiple sequential circuits is reset. FIG. 12 is a diagram schematically illustrating a situation after shift data is set to each of the multiple sequential circuits.

FIG. 13 is a diagram schematically illustrating a situation after the shift data is shifted out.

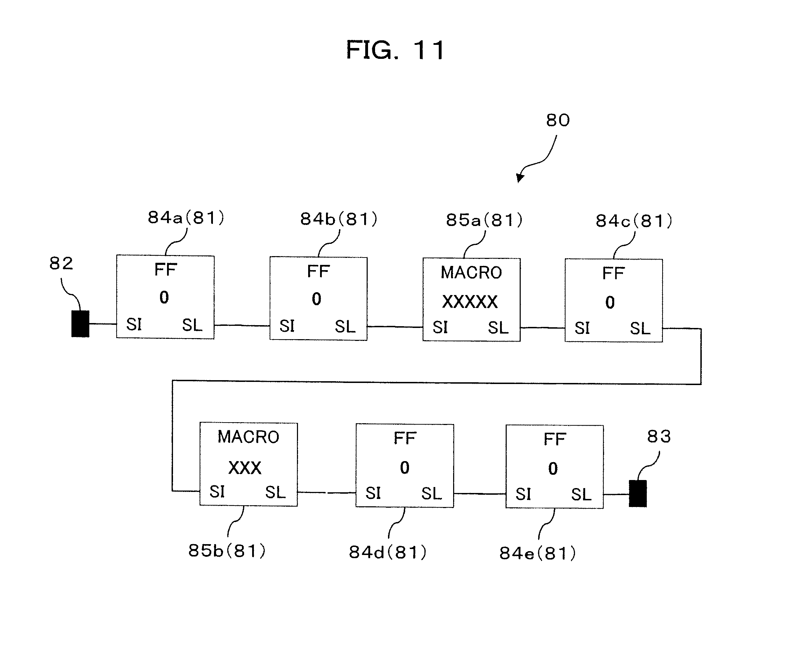

In a scan test using the conventional scan chain 80, after internal information of each of the multiple sequential circuits 81 is reset, desired shift data is shifted in from the SI pin 82, which is thereafter shifted out from the SO pin 83. More specifically, firstly, a reset signal is input into the reset signal input terminal CL of each of the multiple sequential circuits 81, thereby resetting each of the multiple sequential circuits 81, as depicted in FIG. 11 (the symbols "X" in FIG. 11 represent uncertain values as the initial values).

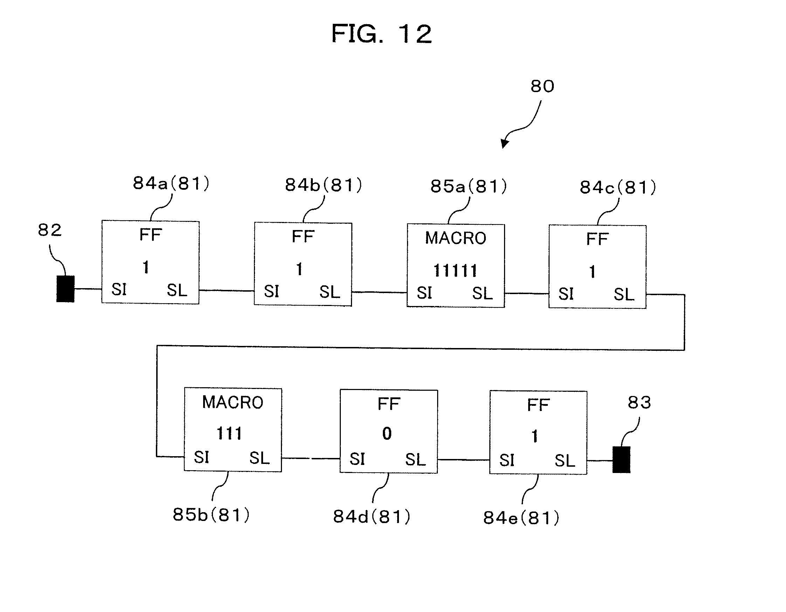

Next, when 13-bit shift data of "1011111111111" is shifted in once each of the multiple sequential circuits 81 is reset, the scan chain 80 executes shift operations to set shift data to each of the multiple sequential circuits 81, as depicted in FIG. 12.

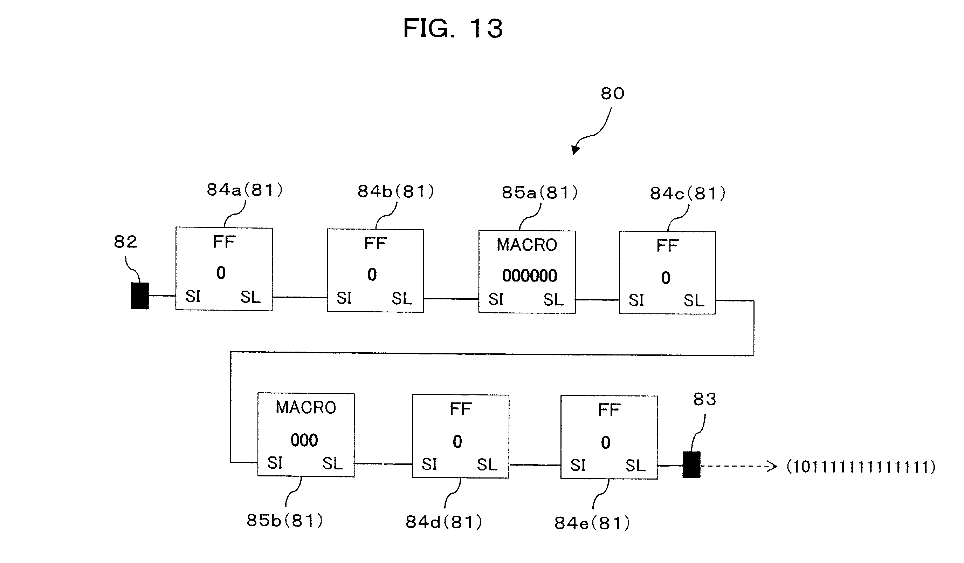

Thereafter, after the shift data that has been set to each of the multiple sequential circuits 81 is shifted out, the scan chain 80 executes shift operations and outputs 13-bit output data array of "1011111111111" corresponding to the shift data, as depicted in FIG. 13.

An operator or the like determines whether or not there is any fault, such as fixed fault, in the flip-flops 84 and the macro 85 constituting the scan chain 80 by comparing the expected value "1011111111111" and the output data array corresponding to the shift data.

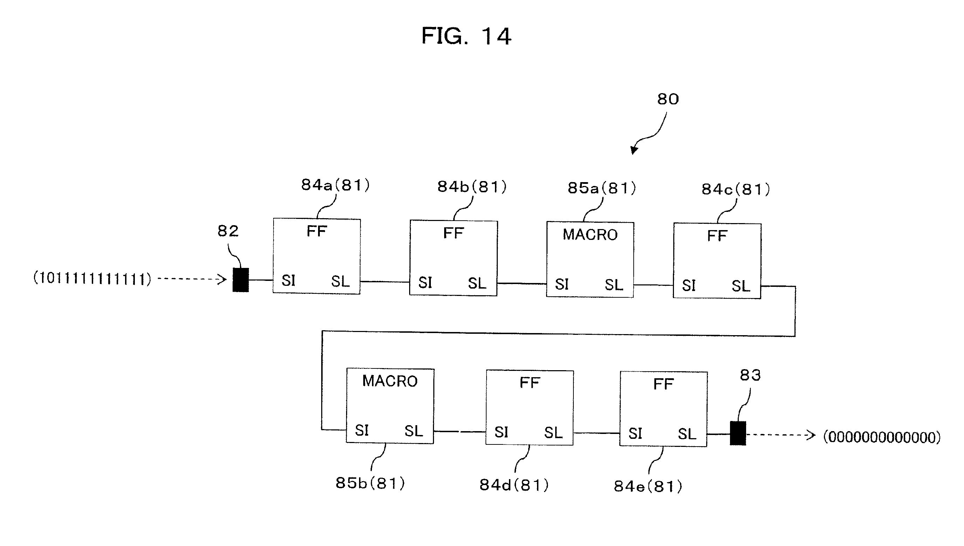

FIG. 14 is a diagram schematically illustrating an example in which the scan test fails in the conventional scan test technique depicted in FIGS. 11-13.

As a result of the comparison between expected value and the output data array corresponding to the shift data, as depicted in FIG. 14, it is depicted that the output data array is "0000000000000" but the expected value is "1011111111111", which indicates a failed scan test. The result suggests that one or more of the multiple sequential circuits 81 constituting the scan chain 80 is fixed to "0" (fixed to "Low"). The test reveals that one or more of the multiple sequential circuits 81 constituting the scan chain 80 is failed and causes an erroneous operation.

Patent Document 1: Japanese Laid-Open Patent Publication No. 2004-12420
Patent Document 2: Japanese Laid-Open Patent Publication No. 2005-134180

DISCLOSURE OF THE INVENTION

ISSUES TO BE SOLVED BY THE INVENTION

However, the above-described conventional scan test technique cannot provide information on where is a faulty site in the multiple sequential circuits constituting the scan chain and the count of a faulty site when the scan test fails.

Accordingly, there is a problem in that identifying a faulty site is very difficult and time-consuming since identification of a faulty site and the cause there should be done for each of the multiple sequential circuits constituting the scan chain in order to identify a faulty site in the scan chain.

The present invention was conceived in light of the above-identified problem, and an object thereof is to easily and quickly identify a faulty site in a scan chain during a scan test.

MEANS TO SOLVE THE ISSUES

In order to achieve the above-identified object, a faulty site identification apparatus of the present invention is characterized by a faulty site identification apparatus for identifying a faulty site in an integrated circuit, the apparatus including: a scan chain that is constituted by coupling a plurality of sequential circuits, the scan chain outputs an output data array by shifting out setting data that is set to each of the plurality of sequential circuits; a setting section that sets a predefined value to at least one sequential circuit of the plurality of sequential circuits as the setting data; an identification section that identifies a faulty site in the scan chain on the basis of the output data array from the scan chain to which the predefined value is set to the at least one sequential circuit as the setting data by the setting section and a location of the at least one sequential circuit in the scan chain.

In addition, at least one sequential circuit is preferably a faulty site identification circuit that is specially provided to identify a faulty site in the scan chain

Furthermore, preferably, the sequential circuits other than the faulty site identification circuit are general functional circuits that function during a normal operation of the integrated circuit, and the faulty site identification circuit is provided between the general functional circuits that are adjacent to each other in the scan chain.

In addition, the identification section preferably identifies a faulty site in the scan chain on the basis of the output data array having the same bit count as the total sum of bit counts of the setting data that is set to each of the plurality of sequential circuits.

Furthermore, preferably, a reset section that resets the plurality of sequential circuits is further provided, and the setting section sets a predefined value to at least one sequential circuit of the plurality of sequential circuits that are reset by the reset section as the setting data.

In addition, the identification section may identify a faulty site in the scan chain by comparing the output data array from the scan chain to which the predefined value is set to the at least one sequential circuit as the setting data by the setting section with an expected value.

Furthermore, a faulty site identification method of the present invention is characterized by a faulty site identification method for identifying a faulty site in an integrated circuit including a scan chain that is constituted by coupling a plurality of sequential circuits, the scan chain is adapted to output an output data array by shifting out setting data that is set to each of the plurality of sequential circuits, the method including: setting a predefined value to at least one sequential circuit of the plurality of sequential circuits as the setting data; outputting an output data array by shifting out the scan chain; identifying a faulty site in the scan chain on the basis of the output data array that is output in the outputting the output data array and a location of the at least one sequential circuit in the scan chain.

In addition, at least one sequential circuit is preferably a faulty site identification circuit that is specially provided to identify a faulty site in the scan chain.

Furthermore, preferably, the sequential circuits other than the faulty site identification circuit are general functional circuits that function during a normal operation of the integrated circuit, and the faulty site identification circuit is provided between the general functional circuits that are adjacent to each other in the scan chain.

In addition, the outputting step which outputs data array may includes outputting the output data array having the same bit count as the total sum of bit counts of the setting data that is set to each of the plurality of sequential circuits.

Furthermore, resetting the plurality of sequential circuits prior to the setting the predefined value as the setting data is preferably further provided.

In addition, the identifying a faulty site in the scan chain may include identifying a faulty site in the scan chain by comparing the output data array that is output at the outputting step which outputs data array with an expected value.

Furthermore, an integrated circuit of the present invention is characterized by an integrated circuit, including: a scan chain that is constituted by coupling a plurality of sequential circuits, the scan chain outputs an output data array by shifting out setting data that is set to each of the plurality of sequential circuits, wherein at least one sequential circuit of the plurality of sequential circuits is a faulty site identification circuit for identifying a faulty site in the scan chain.

In addition, a predefined value is preferably set to the faulty site identification circuit as the setting data during a scan test.

Furthermore, preferably, the faulty site identification circuit is specially provided to identify a faulty site in the scan chain.

In addition, preferably, the sequential circuits other than the faulty site identification circuit are general functional circuits that function during a normal operation of the integrated circuit, and the faulty site identification circuit is provided between the general functional circuits that are adjacent to each other in the scan chain.

Furthermore, the output data array preferably has the same bit count as the total sum of bit counts of the setting data that is set to each of the plurality of sequential circuits.

EFFECTS OF THE INVENTION

The present invention includes at least one of the following advantages:

(1) It is possible to determine whether or not the scan chain is operating normally.
(2) It is possible to easily and quickly identify a faulty site in the scan chain.
(3) It is possible to easily identify a faulty site in both the "Low"-fixed and "High"-fixed types.

(4) Identification of faulty sites in the scan chain, and analyzing and addressing the cause thereof can be achieved efficiently in terms of time and costs.

BRIEF DESCRIPTION OF DRAWINGS

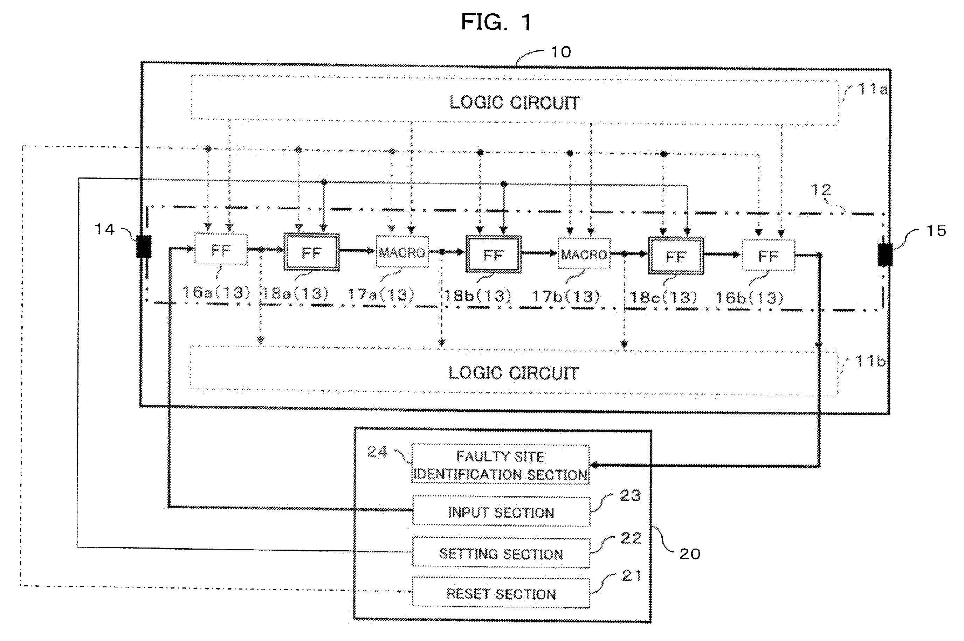

[FIG. 1] Diagram schematically illustrating an example of the configuration of an integrated circuit and a faulty site identification apparatus as one embodiment of the present invention;

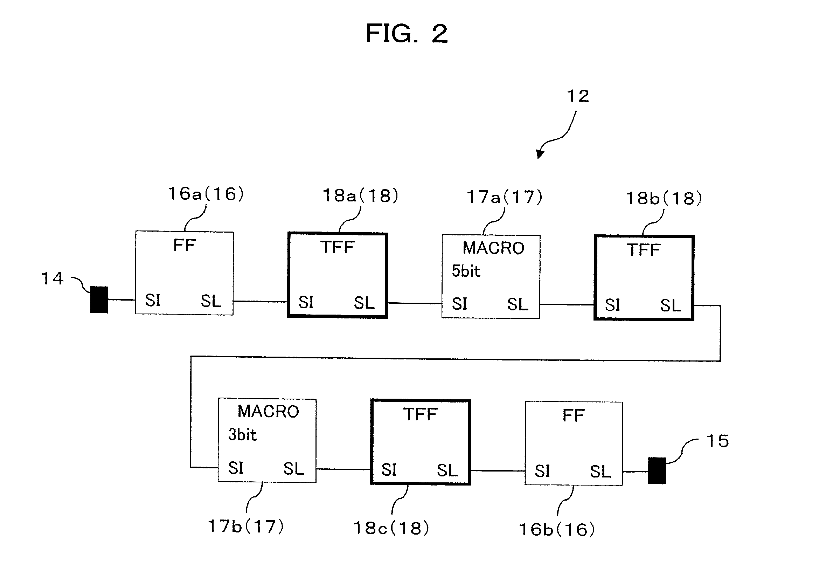

[FIG. 2] Diagram schematically illustrating an example of the configuration of a scan chain formed in an integrated circuit as one embodiment of the present invention;

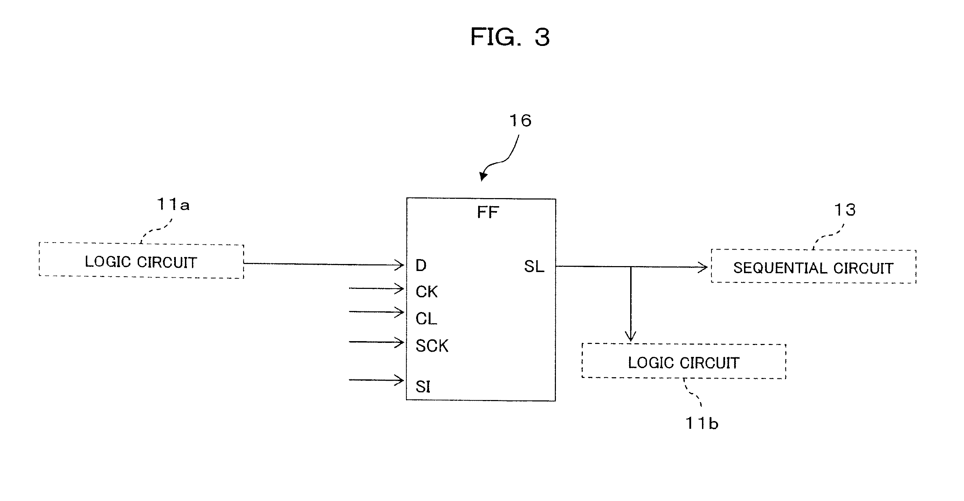

[FIG. 3] Diagram schematically illustrating an example of the configuration of a general flip-flop in the integrated circuit as one embodiment of the present invention;

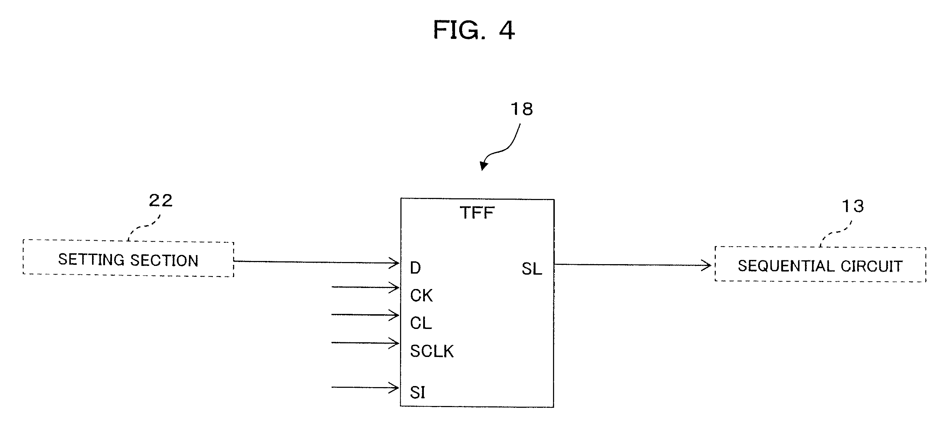

[FIG. 4] Diagram schematically illustrating the configuration of a testing flip-flop in the integrated circuit as one embodiment of the present invention;

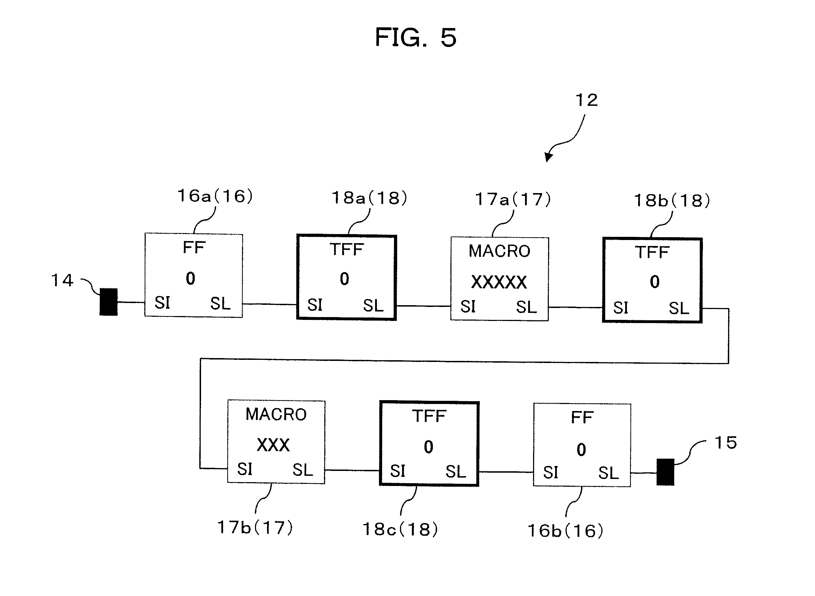

[FIG. 5] Diagram illustrating the scan chain after being reset by a reset section in the faulty site identification apparatus as one embodiment of the present invention;

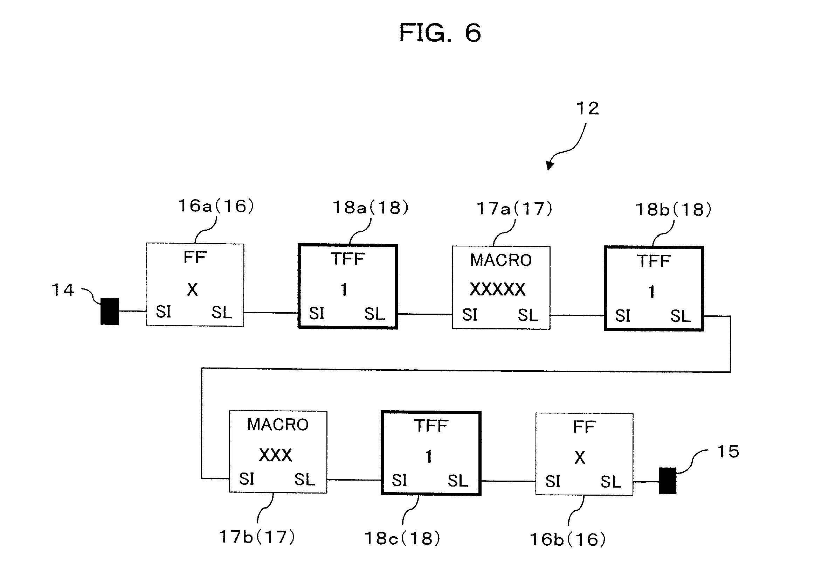

[FIG. 6] Diagram illustrating the scan chain after setting data is set by a setting section in the faulty site identification apparatus as one embodiment of the present invention;

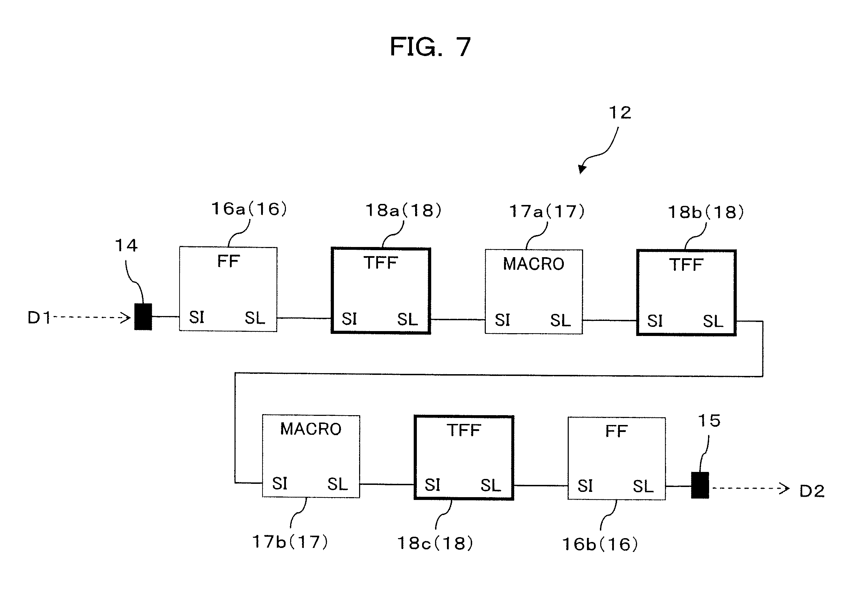

[FIG. 7] Diagram illustrating the scan chain after the setting data is shifted out in the integrated device as one embodiment of the present invention;

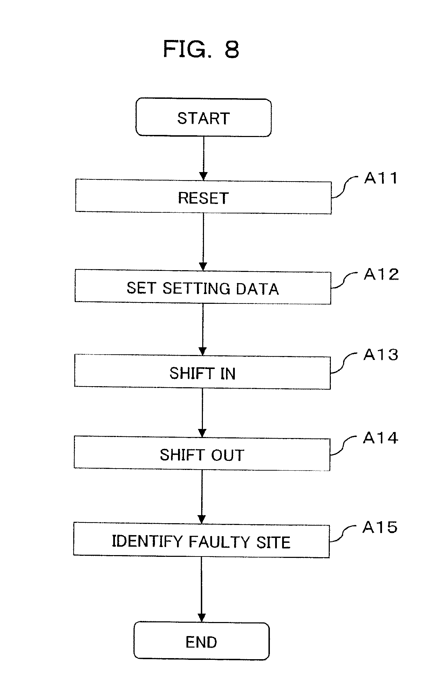

[FIG. 8] Flowchart illustrating one example of a faulty site identification procedure for a scan chain in the faulty site identification apparatus as one embodiment of the present invention;
[FIG. 9] Diagram schematically illustrating an example of the configuration of a conventional scan chain;
[FIG. 10] Diagram schematically illustrating an example of the configuration of a flip-flop constituting the conventional scan chain;
[FIG. 11] Diagram illustrating an example of a scan test technique using a conventional scan chain, and is a diagram schematically illustrating a situation after each of the multiple sequential circuits is reset;
[FIG. 12] Diagram illustrating an example of a scan test technique using a conventional scan chain, and is a diagram schematically illustrating a situation after primary shift data is set to each of the multiple sequential circuits;
[FIG. 13] Diagram illustrating an example of a scan test technique using a conventional scan chain, and is a diagram schematically illustrating a situation after secondary shift data is set to each of the multiple sequential circuits; and
[FIG. 14] Diagram schematically illustrating an example in which a scan test using a conventional scan chain scan test technique fails.

DESCRIPTION OF REFERENCE CHARACTERS

| 10 | Integrated Circuit |
| 11a, 11b | Logic Circuit |
| 12, 80 | Scan Chain |
| 13, 81 | Sequential Circuit |
| 14, 82 | SI Pin |
| 15, 83 | SO Pin |
| 16, 16a, 16b | General Flip-Flop (Sequential Circuit) |
| 17a, 17b | Macro (Sequential Circuit) |

| 18, 18a, 18b, 18c | Testing flip-flop (Sequential Circuit) |
| 20 | Faulty Site Identification Apparatus |
| 21 | Reset Section |
| 22 | Setting Section |
| 23 | Input Section |
| 24 | Faulty Site Identification Section |
| 84, 84a-84e | Flip-Flop |
| 85a, 85b | Macros |

BEST MODES FOR CARRYING OUT THE INVENTION

Hereinafter, embodiments of the prevent invention will be described with reference to the drawings.

1. One Embodiment of the Present Invention

FIG. 1 is a diagram schematically illustrating an example of the configuration of an integrated circuit and a faulty site identification apparatus as one embodiment of the present invention, and FIG. 2 is a diagram schematically illustrating an example of the configuration of a scan chain formed in that integrated circuit.

Firstly, an integrated circuit 10 as one embodiment of the present invention will be described.
The integrated circuit 10 according to one embodiment of the present invention is a semiconductor integrated circuit that adopts a design for testability called "scan design," and is configured to include multiple (two in the example depicted in FIG. 1) logic circuits 11a and 11b, and multiple (seven in the example depicted in FIG. 1) sequential circuits 13, as depicted in FIG. 1.

Note that a detailed description of the logic circuit 11a and 11b is omitted since they are well-known circuits that function during the normal operation (system operation) of the integrated circuit 10.
The sequential circuits 13 are set with data from the logic circuit 11a and 11b included in the integrated circuit 10 and a setting section 22 (which will be described later) as setting data, and in the example depicted in FIGS. 1 and 2, for example, are embodied by general flip-flops (labeled as "FF" in the drawings) 16a and 16b, macros (specific macros) 17a and 17b, and testing flip-flops (faulty site identification circuits; labeled as "TFF" in the drawings) 18a-18c. In addition, the general flip-flop 16a and 16b and the macros 17a and 17b are general functional circuits that function during the normal operation of the integrated circuit 10.

The scan chain 12 is constituted by these sequential circuits 13.
The scan chain 12 is constituted by coupling the multiple sequential circuits 13 in series, and is configured as a circuit different from the circuits that function during a normal operation (system operation) circuit of the integrated circuit 10. That is, the multiple sequential circuits 13 constitute a daisy chain.
In addition, an SI pin 14 and an SO pin 15 are provided at the two ends of the scan chain 12. The SI pin 14 is an entry of shift data that is entered to the scan chain 12, and the SO pin 15 is an exit of the shift data.

As used herein, "shift data" refers to data that is used to assess whether or not a circuit included in the integrated circuit 10 conforms to the required criteria, and sometimes referred to as test vectors.
In the example depicted in FIGS. 1 and 2, the scan chain 12 is constituted by coupling the sequential circuits 13 in series; more specifically, a first general flip-flop 16a, a first testing flip-flop 18a, a first macro 17a, a second testing flip-flop 18b, a second macro 17b, a third testing flip-flop 18c, and a second general flip-flop 16b, in this sequence from the SI pin 14 to the SO pin 15.

That is, the testing flip-flops 18 are provided between the general functional circuits 16 and 17 that are adjacent to each other in the scan chain 12, and it is regarded that at least one sequential circuit 13 of the multiple sequential circuits 13 includes a testing flip-flop 18 in the scan chain 12.
Note that the reference symbols 16a, 16b are used when a reference to a specific one of the general flip-flops is required to be made while reference symbol 16 is used when reference is made to any one of the general flip-flops. Note that the reference symbols 17a, 17b are used when a reference to a specific one of the macros is required to be made while reference symbol 17 is used when reference is made to any of the macros. Note that the reference symbols 18a-18c are used when a reference to a specific one of the testing flip-flops is required to be made while reference symbol 18 is used when reference is made to any one of the testing flip-flops.

FIG. 3 is a diagram schematically illustrating an example of the configuration of a general flip-flop in the integrated circuit as one embodiment of the present invention.
A general flip-flop 16 is set with 1-bit data as setting data, and is configured to include a data input terminal D, a clock signal input terminal CK, a shift data input terminal SI, a scan clock signal input terminal SCK, a data output terminal SL, and a reset signal input terminal CL, as depicted in FIG. 3.

The data input terminal D receives data to be set from a logic circuit 11a as setting data, and a clock signal that is used for setting (capturing) the setting data is entered (applied) to the clock signal input terminal CK.

Into the general flip-flop 16, 1-bit data from the logic circuit 11a is set as setting data via the data input terminal D every time a clock signal is entered to the clock signal input terminal CK.

The shift data input terminal SI of the general flip-flop 16 receives data from the previous-stage sequential circuit 13 in the scan chain 12, and a scan clock signal for executing a shift operation in the scan chain 12 during a scan test is entered (applied) to the scan clock signal input terminal SCK.

As used herein, the "shift operation" refers to an operation in the scan chain 12 wherein shift data is sequentially entered (shifted in) from the SI pin 14 on a bit-by-bit basis and the setting data that has been set to each of the multiple sequential circuits 13 is sequentially output (shifted out) from the SO pin 15 on a bit-by-bit basis.

The data output terminal SL outputs the setting data that has been set to the logic circuit 11b and the next-stage sequential circuit 13 in the scan chain 12.

The general flip-flop 16 captures 1-bit data from the shift data input terminal SI as well as executing a shift operation by outputting 1-bit setting data that has been internally set from the data output terminal SL to the next-stage sequential circuit 13 every time a scan clock signal is entered to the scan clock signal input terminal SCK.

A reset signal for resetting the internal information is entered (applied) to the reset signal input terminal CL.

Thus, in the general flip-flop 16, 1-bit data from the logic circuit 11a is set as setting data in response to an input of a clock signal, a 1-bit shift operation is executed in the scan chain 12 in response to an input of a scan clock signal, and the information set internal to the general flip-flop 16 is reset in response to an input of a reset signal.

A macro 17 is adapted to be set with multiple-bit data as setting data, and includes multiple flip-flops, for example, and is configured to be scannable.

In this embodiment, as depicted in FIG. 2, into the first macro 17a, 5-bit data is set as setting data, and into the second macro 17b, 3-bit data is set as setting data.

In addition, a macro 17 is configured to include a shift data input terminal SI and a data output terminal SL, as depicted in FIG. 2.

Data from the previous-stage sequential circuit 13 in the scan chain 12 is entered to the shift data input terminal SI of the macro 17 on a bit-by-bit basis.

The data output terminal SL in the macro 17 outputs the setting data that has been set to the logic circuit 11a and the next-stage sequential circuit 13 in the scan chain 12 on a bit-by-bit basis.

Note that although the macro 17 is configured to include a data input terminal D, a clock signal input terminal CK, a scan clock signal input terminal SCK, a reset signal input terminal CL, and the like, in addition to the shift data input terminal SI and the data output terminal SL described above, an illustration of these as well as a description thereof are omitted for the brevity of the description since they have the same functions and configurations as those in the general flip-flop 16 and are well-known art.

Thus, in the macro 17, multiple-bit data (5 bits for the macro 17a, for example) from the logic circuit 11a is set as setting data in response to an input of a clock signal, a 1-bit shift operation is executed in the scan chain 12 in response to an input of a scan clock signal, and the information set internal to the macro 17 is reset in response to an input of a reset signal.

FIG. 4 is a diagram schematically illustrating the configuration of a testing flip-flop in the integrated circuit as one embodiment of the present invention.

The testing flip-flop 18 is a flip-flop to which 1-bit data is set as setting data, and is specifically provided for identifying a faulty site in the scan chain 12 in this embodiment. The testing flip-flop 18 is not connected to the logic circuit 11a or 11b, and is prohibited from functioning during the normal operation (system operation) of the integrated circuit 10.

The testing flip-flop (labeled as "TFFs" in the drawings) 18 is configured to include a data input terminal D, a data output terminal SL, a clock signal input terminal CK, a shift data input terminal SI, a scan clock signal input terminal SCK, and a reset signal input terminal CL, as depicted in FIG. 4.

The data input terminal D receives data from the setting section 22 (which will be described later), and the data output terminal SL outputs the setting data that has been set to the next-stage sequential circuit 13 in the scan chain 12.

Note that a detailed description of the clock signal input terminal CK, the shift data input terminal SI, the scan clock signal input terminal SCK and the reset signal input terminal CL is omitted since they have the same functions and configurations as those in the general flip-flop 16.

Thus, in the testing flip-flop 18, 1-bit data from the setting section 22 (which will be described later) is set as setting data in response to an input of a clock signal, a 1-bit shift operation is executed in the scan chain 12 in response to an input of a scan clock signal, and the information set internal to the testing flip-flop 18 is reset in response to an input of a reset signal.

The scan chain 12 receives (is shifted in) shift data from the SI pin 14, carries out a shift operation, thereby outputting an output data array D2 from the SO pin 15. Note that a specific example of the output data array D2 will be described later.

Next, the faulty site identification apparatus 20 as one embodiment of the present invention will be described.

The faulty site identification apparatus 20 according to one embodiment of the present invention is adapted to identify a faulty site in the scan chain 12 in the integrated circuit 10 configured as described above, and is configured to include, a reset section 21, a setting section 22, an input section 23, and a faulty site identification section (identification section) 24, as depicted in FIG. 1.

FIG. 5 is a diagram illustrating the scan chain after being reset by the reset section in the faulty site identification apparatus as one embodiment of the present invention.

The reset section 21 resets the sequential circuits 13, and outputs reset signals to all of the sequential circuits 13 constituting the scan chain 12 when a scan test is commenced, as depicted in FIG. 1, for example.

In the example depicted in FIG. 5, the reset section 21 sets a value of "0" to each of the first general flip-flop 16a, the first testing flip-flop 18a, the second testing flip-flop 18b, the third testing flip-flop 18c, and the second general flip-flop 16b, sets "XXXXX" to the first macro 17a as the initial value, and sets "XXX" to the second macro 17b as the initial value by inputting reset signals (High) to all of the sequential circuits 13 constituting the scan chain 12.

As used hereinafter, "X" represents a uncertain value of "0" or "1" that is input from the logic circuit 11a.

FIG. 6 is a diagram illustrating the scan chain after setting data is set by the setting section in the faulty site identification apparatus as one embodiment of the present invention.

The setting section 22 sets predefined values to the testing flip-flops 18 as setting data, and sets "1" to all of the testing flip-flops 18 constituting the scan chain 12 as a predefined value in response to an input of a clock signal to the testing flip-flop 18 in this embodiment.

In the example depicted in FIG. 6, the setting section 22 sets "1" to each of the first testing flip-flop 18a, the second testing flip-flop 18b, and the third testing flip-flop 18c as setting data.

More specifically, the setting section 22 is configured as a circuit that provides "High" to each of the testing flip-flops 18, and each testing flip-flop 18 captures "1" as a predefined value in response to an input of a clock signal to the testing flip-flop 18, for example.

In addition, clock signals are input to all of the sequential circuits 13 constituting the scan chain 12 in sync.

Accordingly, in response to clock signals being input to all of the sequential circuits 13 constituting the scan chain 12 in sync, "1" is set to each of the first testing flip-flop 18a, the second testing flip-flop 18b, and the third testing flip-flop 18c as setting data, and the data "X" from the logic circuit 11a is set to each of the first general flip-flop 16a and the second general flip-flop 16b as setting data, as depicted in FIG. 6. Furthermore, the 5-bit data "XXXXX" from the logic circuit 11a is set to the first macro 17a as setting data, and the 3-bit data "XXX" from the logic circuit 11a is set to the second macro 17b as setting data.

FIG. 7 is a diagram illustrating the scan chain after the setting data is shifted out in the integrated device as one embodiment of the present invention.

The input section 23 shifts in shift data D1 having a predetermined bit count to the scan chain 12, as depicted in FIG. 7, and captures the shift data D1 from the SI pin 14 on a bit-by-bit basis every time scan clock signals are input into all of the sequential circuits 13 constituting the scan chain 12 in sync.

Note that the value of the shift data D1 may be set to any value provided that the shift data D1 has the same bit count as an output data array D2.

In addition, the input section 23 shifts in the shift data D1 that has the same bit count as the total sum of bit counts of setting data that is set to each of the multiple sequential circuits 13, for example.

That is, in this embodiment, since the total sum of bit counts of setting data that is set to each of the first general flip-flop 16a, the first testing flip-flop 18a, the first macro 17a, the second testing flip-flop 18b, the second macro 17b, the third testing flip-flop 18c, and the second general flip-flop 16b is 13, 13 scan clock signals are input to each of these multiple sequential circuits 13 in sync.

Thereby, the scan chain 12 executes a shift operation of 13-bit data and outputs the 13-bit output data array D2 from the SO pin 15.

In response to the shift data D1 being shifted in to the SI pin 14 of the scan chain 12 once the setting data as depicted in FIG. 6 has been set to each of the sequential circuits 13 constituting the scan chain 12, the scan chain 12 outputs one of the following values (a)-(e) as the output data array D2, for example.

```
"X1XXX1XXXXX1X"   ... (a)
```

```
"0000000000000"   ... (b)
```

```
"X1XXX00000000"   ... (c)


"X1XXX1XXXXX00"   ... (d)


"X1XXX1XXXXX10"   ... (e)
```

Note that since the scan chain 12 sequentially shifts out the setting data from the sequential circuit 13 that is located closest to the SO pin 15 to the sequential circuit 13 that is located closest to the SI pin 14, the output data array D2 is arranged from the left to the right of its bit array in the order of being output from the SO pin 15. That is, the setting data for the general flip-flop 16b that is located closest to the SO pin 15 in the scan chain 12 is depicted as being positioned at the leftmost end of the output data array D2.

Thus, the input section 23 shifts in the shift data D1 having the same bit count as the total sum of bit counts of setting data that is set to each of the multiple sequential circuits 13 to the scan chain 12, which allows the scan chain 12 to output the output data array D2 having the same bit count as the total sum of bit counts of setting data that is set to each of the multiple sequential circuits 13.

The faulty site identification section 24 is adapted to identify a faulty site in the scan chain 12, and is configured to identify the a faulty site in the scan chain 12 on the basis of the output data array D2 from the scan chain 12 in which a predefined value has been set to the testing flip-flops 18 as setting data by the setting section 22 and the locations of the testing flip-flops 18 in the scan chain 12. In this embodiment, the faulty site identification section 24 identifies a faulty site in the scan chain 12 by comparing the output data array D2 from the scan chain 12 in which a predefined value has been set to the testing flip-flops 18 as setting data by the setting section 22 with an expected value.

As used herein, the "expected value" refers to a value that is expected to be obtained when the setting data that has been set to the scan chain 12 from the setting section 22 and the logic circuit 11a is output from the scan chain 12. More specifically, in FIGS. 6 and 7, the faulty site identification section 24 determines that the scan chain 12 works normally if the actually obtained value of the output data array D2 has the above value (a) and the expected value is "X1XXX1XXXXX1X", since the expected value and the output data array D2 agree with each other.

Otherwise, the faulty site identification section 24 determines that the scan test is failed if the actually obtained value of the output data array D2 is one of the above values (b)-(c), since the expected value and the output data array D2 do not agree with each other. That is, the faulty site identification section 24 determines that one or more of the multiple sequential circuits 13 constituting the scan chain 12 fail, causing an erroneous operation.

The faulty site identification section 24 then locates the faulty site in the scan chain 12 on the basis of the output data array D2 and the locations of the testing flip-flops 18 in the scan chain 12 when determining that the scan test is in the failed status.

More specifically, the faulty site identification section 24 compares the bits corresponding to the testing flip-flops 18 in the expected value and the bits corresponding to the testing flip-flops 18 in the output data array D2, and identifies the sequential circuit 13 that is located immediate downstream to the testing flip-flop 18 corresponding to the unmatched bit as a faulty site.

For example, if the output data array D2 has the above value (b), the faulty site identification section 24 determines that the setting data "1" that has been set to the third testing flip-flop 18c is not correctly output since the second bit from the left is "0" in the above value (b). Thereby, the faulty site identification section 24 identifies the second general flip-flop 16b as a faulty site and classifies the failure as a fixed-to-"Low" state in which the second general flip-flop 16b is fixed to "0."

In addition, if the output data array D2 has the above value (c), for example, the faulty site identification section 24 determines that the setting data "1" that has been set to the second testing flip-flop 18b is not correctly output since the value of the second bit from the left is "1" but the sixth bit from the left in the above value (c) is "0." Thereby, the faulty site identification section 24 identifies the second macro 17b as a faulty site and classifies the failure as a status in which the second macro 17b is fixed to "0".

Furthermore, if the output data array D2 has the above value (d), for example, the faulty site identification section 24 determines that the setting data "1" that has been set to the first testing flip-flop 18a is not correctly output since the values of the second and sixth bits from the left are "1" but the twelfth bit from the left in the above value (d) is "0." Thereby, the faulty site identification section 24 identifies the first macro 17a as a faulty site and classifies the failure as a status in which the first macro 17a is fixed to "0".

In addition, if the output data array D2 has the above value (e), for example, the faulty site identification section 24 determines that the setting data "X" that has been set to the first general flip-flop 16a is not correctly output since the values of the second, sixth, and twelfth bits from the left are "1" but the thirteenth bit from the left in the above value (e) is "0." Thereby, the faulty site identification section 24 identifies the first general flip-flop 16a as a faulty site and classifies the failure as a status in which the first general flip-flop 16a is fixed to "0".

A faulty site identification procedure in the scan chain 12 executed in the faulty site identification apparatus 20 configured as described above according to one embodiment of the present invention will be described with reference to the flowchart (steps A11-A15) depicted in FIG. 8 together with FIGS. 5-7.

Firstly, the reset section 21 outputs reset signals when a scan test is commenced to reset all of the sequential circuits 13 constituting the scan chain 12 (step A11; reset step, see FIG. 5).

Next, in response to clock signals being input to each of the multiple sequential circuits 13 in sync once each of the multiple sequential circuits 13 has been reset, the setting section 22 sets a predefined value of "1" to all of the testing flip-flops 18 constituting the scan chain 12 as setting data (step A12; setting step). In this step, once the clock signals are entered to each of the multiple sequential circuits 13 in sync, data from the logic circuit 11a is set to each of the first general flip-flop 16a, the first macro 17a, the second macro 17b, and the second general flip-flop 16b as setting data (see FIG. 6).

The input section 23 then shifts in the shift data D1 to the scan chain 12 (step A13). The scan chain 12 executes a shift operation every time scan clock signals are entered to the testing flip-flops 18, and outputs the output data array D2 having the same bit count as that of the shift data D1 from the scan chain 12 (step A14; output step, see FIG. 7).

The faulty site identification section 24 identifies a faulty site in the scan chain 12 on the basis of the output data array D2 output from the scan chain 12 and the locations of the testing flip-flops 18 in the scan chain 12 (step A15; identification step).

As described above, according to the integrated device 10 and the faulty site identification apparatus 20 as one embodiment of the present invention, since a faulty site is identified on the basis of the output data array D2 obtaining by setting "1" to the testing flip-flops 18 as a predefined value and shifting out from the scan chain 12 and the locations of the testing flip-flops 18, it is possible to easily and quickly identify a faulty site fixed to "Low" in the multiple sequential circuits 13 constituting the scan chain 12, in addition to being able to determine whether or not the scan chain 12 is operating normally.

In addition, by comparing the bits corresponding to the testing flip-flops 18 in the expected value and the bits corresponding to the testing flip-flops 18 in the output data array D2, and identifying the sequential circuit 13 that is located immediate downstream to the testing flip-flop 18 corresponding to the unmatched bit as a faulty site, it is possible to easily identify a faulty site in the scan chain 12.

Furthermore, by identifying a faulty site on the basis of the output data array D2 having the same bit count as the total sum of bit counts of setting data that is set to each of the multiple sequential circuits 13 constituting the scan chain 12, it is possible to more easily identify a faulty site in the scan chain 12.

In addition, provision of the testing flip-flops 18 that do not function during the normal operation (system operation) of the integrated circuit 10 to the integrated circuit 10 is effective in terms of time and costs to analyze and address the cause of a failure in the scan chain 12.

2. Others

Note that the present invention is not limited to the embodiment described above, and various modifications may be made without departing from the spirit of the present invention.

For example, although the above-described embodiment has been described using the example in which "1" is set to the testing flip-flops 18 as a predefined value, the present invention is not limited to this and "0" may be set to the testing flip-flops 18 as a predefined value or either one of "1" and "0" may be selectively set as a predefined value.

In the case where "0" is set to the testing flip-flops 18 as a predefined value, "0" may be set to the testing flip-flops 18 as a predefined value by resetting the scan chain 12 using the reset section 21.

The scan chain 12 then may output any one of the following values (f)-(j) as the output data array D2 in response to the shift data D1 is input once reset by the reset section 21.

```
"00XXX0XXXXX00"  ... (f)
```

```
"111111111111"  ... (g)
```

```
"00XXX0XXXXX11"   ... (h)


"00XXX0XXXXX11"   ... (i)


"00XXX0XXXXX01"   ... (j)
```

In addition, the faulty site identification section 24 identifies a faulty site in the scan chain 12 by comparing the output data array D2 with an expected value.

More specifically, the faulty site identification section 24 determines that the scan chain 12 works normally if the actually obtained value of the output data array D2 has the above value (f) and the expected value is "00XXX0XXXXX00", since the expected value and the output data array D2 agree with each other. Otherwise, the faulty site identification section 24 determines that the scan test is failed if the actually obtained value of the output data array D2 is one of the above values (g)-(j), since the expected value and the output data array D2 do not agree with each other.

The faulty site identification section 24 then locates the faulty site in the scan chain 12 on the basis of the output data array D2 and the locations of the testing flip-flops 18 in the scan chain 12 when determining that the scan test is in the failed status.

For example, if the output data array D2 has the above value (g), the faulty site identification section 24 determines that the setting data "0" that has been set to the third the testing flip-flop 18c is not correctly output since the second bit from the left is "1" in the above value (g). Thereby, the faulty site identification section 24 identifies the second general flip-flop 16b as a faulty site and classifies the failure as a fixed-to-"High" state in which the second general flip-flop 16b is fixed to "1" (see FIG. 7).

In addition, if the output data array D2 has the above value (h), for example, the faulty site identification section 24 determines that the setting data "0" that has been set to the second testing flip-flop 18b is not correctly output since the value of the second leftmost bit is "0" but the sixth bit from the left in the above value (h) "1." Thereby, the faulty site identification section 24 identifies the second macro 17b as a faulty site and classifies the failure as a status in which the second macro 17b is fixed to "1" (see FIG. 7).

Furthermore, if the output data array D2 has the above value (i), for example, the faulty site identification section 24 determines that the setting data "0" that has been set to the first testing flip-flop 18a is not correctly output since the values of the second and sixth bits from the left are "0" but the twelfth bit from the left in the above value (i) is "1." Thereby, the faulty site identification section 24 identifies the first macro 17a as a faulty site and classifies the failure as a status in which the first macro 17a is fixed to "1" (see FIG. 7).

In addition, if the output data array D2 has the above value (j), for example, the faulty site identification section 24 determines that the setting data "X" that has been set to the first general flip-flop 16a is not correctly output since the values of the second, sixth, and twelfth bits from the left are "0" but the thirteenth bit from the left in the above value (j) is "1." Thereby, the faulty site identification section 24 identifies the first general flip-flop 16a as a faulty site and classifies the failure as a status in which the first general flip-flop 16a is fixed to "1" (see FIG. 7).

As described above, according to the integrated device 10 and the faulty site identification apparatus 20 as a variant of one embodiment of the present invention, since "0" may be set to the testing flip-flops 18 as a predefined value by resetting the testing flip-flops 18, it is possible to easily identify a faulty site that is fixed to "High" in the multiple sequential circuits 13 constituting the scan chain 12, in addition to obtaining the same effects as the above-described embodiment.

In addition, by allowing a value of either "1" or "0" to be set as a predefined value, it is possible to easily and quickly assess a faulty site in both the "Low"-fixed and "High"-fixed types.

Note that although the above-described embodiment has been described using the example in which a predefined value is set to the testing flip-flops 18, this is not limiting and the testing flip-flops 18 may be omitted from the integrated circuit 10 and predefined values may be set to the general flip-flops 16 and/or the macros 17.

In addition, although the reset section 21, the setting section 22, the input section 23, and the faulty site identification section 24 are provided outside the integrated circuit 10 in the above-described embodiment, this is not limiting and any of the reset section 21, the setting section 22, the input section 23, and the faulty site identification section 24 may be provided internal to the integrated circuit 10.

Furthermore, although the scan chain 12 is constituted by alternately coupling the testing flip-flops 18 and the general functional circuits in the above-described embodiment, this is not limiting and the testing flip-flops 18 may be provided to required locations only.

In addition, although the above-described embodiment has been described using the example in which the output data array D2 has the same bit count as the total sum of bit counts of setting data that is set to each of the multiple sequential circuits 13, this is not limiting and the output data array D2 has any bit count as long as a faulty site in the scan chain 12 can be identified, for example.

Note that those ordinary skilled in the art can practice and manufacture the present invention from the disclosure of the present invention.

Industrial Applicability

The present invention is applicable to various integrated circuits in which a predefined value can be set to at least one sequential circuit of multiple sequential circuits constituting a scan chain.

**Claims**

1. A faulty site identification apparatus for identifying a faulty site in an integrated circuit, the faulty site identification apparatus comprising:

   a scan chain constituted by coupling a plurality of sequential circuit elements and adapted to output a scan data by shifting out setting data that is set to each of the plurality of sequential circuits;
   a setting section that sets the setting data to at least one sequential circuit element of the plurality of sequential circuit elements; and
   an identification section that identifies a faulty site in the scan chain on the basis of the scan data from the scan chain to which the setting data is set to the at least one sequential circuit element by the setting section.

2. The faulty site identification apparatus according to claim 1, wherein the at least one sequential circuit element is a faulty site identification circuit element that is provided to identify the faulty site in the scan chain.

3. The faulty site identification apparatus according to claim 2, wherein the sequential circuit elements other than the faulty site identification circuit element are general functional circuit elements that function during a system operation of the integrated circuit, and
the faulty site identification circuit element is provided between the general functional circuit elements that are adjacent to each other in the scan chain.

4. The faulty site identification apparatus according to claims 1 to 3, wherein the identification section identifies a faulty site in the scan chain on the basis of the scan data having the same bit count as the total sum of bit counts of the setting data that is set to each of the plurality of sequential circuit elements.

5. The faulty site identification apparatus according to claims 1 to 4, further comprising a reset section that resets the plurality of sequential circuit elements,
wherein the setting section sets setting data to at least one sequential circuit element of the plurality of sequential circuit elements that are reset by the reset section.

6. The faulty site identification apparatus according to claims 1 to 5, wherein the identification section identifies a faulty site in the scan chain by comparing the scan data from the scan chain with the setting data as an expected value.

7. A faulty site identification method for identifying a faulty site in an integrated circuit comprising a scan chain that is constituted by coupling a plurality of sequential circuit elements, the scan chain is adapted to output a scan data by shifting out setting data that is set to each of the plurality of sequential circuit elements, the method comprising:

   setting the setting data to at least one sequential circuit element of the plurality of sequential circuit elements;
   outputting the scan data by shifting out the scan chain;
   identifying a faulty site in the scan chain on the basis of the scan data that is output in the outputting the scan data.

8. The faulty site identification method according to claim 7, wherein the at least one sequential circuit element is a faulty site identification circuit element that is provided to identify the faulty site in the scan chain.

9. The faulty site identification method according to claim 8, wherein the sequential circuit elements other than the faulty site identification circuit element are general functional circuit elements that function during a system operation of the integrated circuit, and

the faulty site identification circuit element is provided between the general functional circuit elements that are adjacent to each other in the scan chain.

10. The faulty site identification method according to any one of claims 7 to 9, wherein the outputting the scan data having the same bit count as the total sum of bit counts of the setting data that is set to each of the plurality of sequential circuit elements.

11. The faulty site identification method according to any one of claims 7 to 10, further comprising resetting the plurality of sequential circuit elements prior to the setting the setting data.

12. The faulty site identification method according to any one of claims 7 to 11, wherein the identifying a faulty site in the scan chain comprises identifying a faulty site in the scan chain by comparing the scan data from the scan chain with the setting data as an expected value.

13. An integrated circuit, comprising:

a scan chain constituted by coupling a plurality of sequential circuit elements and adapted to output a scan data by shifting out setting data that is set to each of the plurality of sequential circuits,

wherein at least one sequential circuit element of the plurality of sequential circuit elements is a faulty site identification circuit element for identifying a faulty site in the scan chain.

14. The integrated circuit according to claim 13, wherein a setting data is set to the faulty site identification circuit element during a scan test.

15. The integrated circuit according to claim 13 or 14, wherein the faulty site identification circuit element is provided to identify the faulty site in the scan chain.

16. The integrated circuit according to any one of claims 13 to 15, wherein the sequential circuit elements other than the faulty site identification circuit element are general functional circuit elements that function during a system operation of the integrated circuit, and the faulty site identification circuit element is provided between the general functional circuit elements that are adjacent to each other in the scan chain.

17. The integrated circuit according to any one of claims 13 to 15, wherein the scan data has the same bit count as the total sum of bit counts of the setting data that is set to each of the plurality of sequential circuit elements.

## FIG. 1

EP 2 133 705 A1

# FIG. 2

EP 2 133 705 A1

# FIG. 3

FIG. 4

# FIG. 5

12

16a(16)　　18a(18)　　17a(17)　　18b(18)

14

| FF | TFF | MACRO | TFF |
| 0 | 0 | XXXXX | 0 |
| SI　　SL | SI　　SL | SI　　SL | SI　　SL |

| MACRO | TFF | FF |
| XXX | 0 | 0 |
| SI　　SL | SI　　SL | SI　　SL |

15

17b(17)　　18c(18)　　16b(16)

EP 2 133 705 A1

# FIG. 6

# FIG. 7

## FIG. 8

```
          ┌─────────────┐
          │    START    │
          └─────────────┘
                 │
                 ▼
   ┌───────────────────────────┐ ⌐A11
   │           RESET           │
   └───────────────────────────┘
                 │
                 ▼
   ┌───────────────────────────┐ ⌐A12
   │      SET SETTING DATA      │
   └───────────────────────────┘
                 │
                 ▼
   ┌───────────────────────────┐ ⌐A13
   │          SHIFT IN          │
   └───────────────────────────┘
                 │
                 ▼
   ┌───────────────────────────┐ ⌐A14
   │         SHIFT OUT          │
   └───────────────────────────┘
                 │
                 ▼
   ┌───────────────────────────┐ ⌐A15
   │     IDENTIFY FAULTY SITE    │
   └───────────────────────────┘
                 │
                 ▼
          ┌─────────────┐
          │     END     │
          └─────────────┘
```

EP 2 133 705 A1

FIG. 9

80

84a(81)    84b(81)    85a(81)    84c(81)

| FF | FF | MACRO 5bit | FF |
|---|---|---|---|
| SI    SL | SI    SL | SI    SL | SI    SL |

82

| MACRO 3bit | FF | FF |
|---|---|---|
| SI    SL | SI    SL | SI    SL |

83

85b(81)    84d(81)    84e(81)

EP 2 133 705 A1

EP 2 133 705 A1

FIG. 10

84

| FF |
|----|
| D → SL |
| CK |
| CL |
| SCK |
| SI |

# FIG. 11

FIG. 12

EP 2 133 705 A1

## FIG. 13

EP 2 133 705 A1

FIG. 14

80

84a(81)          84b(81)          85a(81)          84c(81)

82

(1011111111111) - - - - - ▶ ■

| FF | | FF | | MACRO | | FF |
|---|---|---|---|---|---|---|
| SI | SL | SI | SL | SI | SL | SI | SL |

| MACRO | | FF | | FF |
|---|---|---|---|---|
| SI | SL | SI | SL | SI | SL |

83

■ - - - - - ▶ (0000000000000)

85b(81)          84d(81)          84e(81)

EP 2 133 705 A1

## INTERNATIONAL SEARCH REPORT

| International application No. |
| --- |
| PCT/JP2007/056903 |

A. CLASSIFICATION OF SUBJECT MATTER
*G01R31/28*(2006.01)i

According to International Patent Classification (IPC) or to both national classification and IPC

B. FIELDS SEARCHED

Minimum documentation searched (classification system followed by classification symbols)
G01R31/28-31/3193

Documentation searched other than minimum documentation to the extent that such documents are included in the fields searched
Jitsuyo Shinan Koho        1922-1996    Jitsuyo Shinan Toroku Koho    1996-2007
Kokai Jitsuyo Shinan Koho   1971-2007    Toroku Jitsuyo Shinan Koho    1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 6-230075 A  (Fujitsu Ltd.), 19 August, 1994 (19.08.94), Full text; all drawings (Family: none) | 1-17 |
| X | JP 7-92230 A  (NEC Engineering Kabushiki Kaisha), 07 April, 1995 (07.04.95), Full text; all drawings (Family: none) | 1-17 |

☐ Further documents are listed in the continuation of Box C.          ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered   to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 21 June, 2007 (21.06.07) | 03 July, 2007 (03.07.07) |

| Name and mailing address of the ISA/ | Authorized officer |
| --- | --- |
| Japanese Patent Office | |
| Facsimile No. | Telephone No. |

Form PCT/ISA/210 (second sheet) (April 2005)

**EP 2 133 705 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004012420 A

- JP 2005134180 A